# EUROPÄISCHE PATENTANMELDUNG

(11) **EP 3 879 004 A1**
(43) Veröffentlichungstag der Anmeldung: **15.09.2021**
(21) Anmeldenummer: 20198682.5
(22) Anmeldetag: 28.09.2020
(51) Int. Cl.: C23C 28/02, C23C 14/06, C23C 18/36, C23C 28/00, C25D 3/56

(54) **VERFAHREN ZUR HERSTELLUNG EINES BESCHICHTETEN BAUTEILS FÜR EINE WASSERARMATUR**

(30) Priorität: 09.03.2020 DE 102020106254
(71) Anmelder: Grohe AG, 58653 Hemer (DE)
(72) Erfinder: ZIMMERMANN, Christian, 58675 Hemer (DE)

(57) **Zusammenfassung**

Die Erfindung betrifft ein Verfahren zur Herstellung eines Bauteils (1) für eine Wasserarmatur, bei dem eine Oberfläche (2) eines Grundkörpers (3) für das Bauteil (1) zumindest teilweise mit einer Beschichtung (4) beschichtet wird, die eine Mehrzahl von Schichten (5, 6, 7, 8) aufweist, wobei zumindest eine Schicht (7) der Beschichtung mit einer Nickel-Phosphor-Legierung gebildet wird und wobei ein Massenanteil des Phosphors in der Nickel-Phosphor-Legierung mindestens 8% beträgt, **dadurch gekennzeichnet, dass** direkt auf zumindest einen Teil dieser Schicht (7) eine weitere Schicht (8) der Beschichtung (4) mittels Gasphasenabscheidung aufgebracht wird.

## Beschreibung

Die Erfindung betrifft ein Verfahren zur Herstellung eines Bauteils für eine Wasserarmatur, wie etwa eine Sanitärarmatur. Zudem wird ein Bauteil für eine Wasserarmatur vorgeschlagen.

Aus der DE 10 2016 004 913 A1 und der WO 2017/182123 A1 sind Verfahren und Bauteile nach dem Oberbegriff der unabhängigen Ansprüche bekannt. Bei dem bekannten Verfahren und dem bekannten Bauteil ist eine galvanisch bzw. elektrolytisch aufgebrachte Chromschicht zwischen einer Nickel-Phosphor-Legierungsschicht und einer PVD- bzw. DLC-Schicht vorgesehen.

Entsprechende galvanische bzw. elektrolytische Verchromungsprozesse verursachen üblicherweise chromhaltige Abwässer, die aufwändig gereinigt werden müssen. Ferner werden zur galvanischen bzw. elektrolytischen Verchromung häufig sogenannte SVHC-Verbindungen (z. B. Chrom(VI)-Verbindungen, Borsäure) verwendet. Nachteile durch den Einsatz dieser Verbindungen liegen insbesondere im Bereich von Arbeitsplatzsicherheit und Umweltschutz.

Hiervon ausgehend ist es eine Aufgabe der Erfindung, die mit Bezug zum Stand der Technik geschilderten Probleme zumindest teilweise zu lösen. Insbesondere sollen ein Verfahren und ein Bauteil angegeben werden, die eine ressourcenschonende und umweltschonende Beschichtung erlauben, die gleichwohl möglichst korrosionshemmend und/oder dekorativ gestaltbar ist.

Diese Aufgaben werden gelöst durch die Merkmale der unabhängigen Patentansprüche. Weitere vorteilhafte Ausgestaltungen der hier vorgeschlagenen Lösung sind in den abhängigen Patentansprüchen angegeben. Es ist darauf hinzuweisen, dass die in den abhängigen Patentansprüchen einzeln aufgeführten Merkmale in beliebiger, technologisch sinnvoller Weise miteinander kombiniert werden können und weitere Ausgestaltungen der Erfindung definieren. Darüber hinaus werden die in den Patentansprüchen angegebenen Merkmale in der Beschreibung näher präzisiert und erläutert, wobei weitere bevorzugte Ausgestaltungen der Erfindung dargestellt werden.

Hierzu trägt ein Verfahren zur Herstellung eines Bauteils für eine Wasserarmatur bei, bei dem eine Oberfläche eines Grundkörpers für das Bauteil zumindest teilweise mit einer Beschichtung versehen bzw. beschichtet wird, die eine Mehrzahl von Schichten aufweist, wobei zumindest eine Schicht der Beschichtung mit einer Nickel-Phosphor-Legierung gebildet wird und wobei ein Massenanteil des Phosphors in der Nickel-Phosphor-Legierung mindestens 8% beträgt. Das Verfahren zeichnet sich dadurch aus, dass direkt auf zumindest einen Teil dieser Schicht eine weitere Schicht der Beschichtung mittels Gasphasenabscheidung aufgebracht wird.

Bei dem Bauteil kann es sich zum Beispiel um ein Armaturengehäuse oder einen Teil handeln. Weiterhin kann es sich bei dem Bauteil beispielsweise um ein Rohrelement und/oder eine Wasserführung handeln. Bei der Wasserarmatur kann es sich beispielsweise um eine Sanitärarmatur handeln. Sanitärarmaturen dienen insbesondere der bedarfsgerechten Bereitstellung von Mischwasser an einem Waschbecken, einem Spülbecken, einer Dusche oder einer Badewanne. Sanitärarmaturen können zum Beispiel Stellglieder für eine Wassertemperatur und/oder einer Entnahmemenge des Wassers umfassen und kommen regelmäßig in einem Sichtbereich eines Benutzers zum Einsatz, sodass diese zum einen eine dekorative Oberfläche aufweisen sollen und zum anderen wirksam gegen Korrosion geschützt werden sollen.

Die Oberfläche des Bauteils wird zumindest teilweise oder vollständig mit einer Beschichtung mit einer Mehrzahl von Schichten beschichtet. Bei der Beschichtung kann es sich um ein Mehrschichtsystem handeln, mit dem insbesondere dekorative und/oder funktionale Oberflächen erzeugbar sind. Die einzelnen Schichten können dazu insbesondere sequenziell ausgebildet werden und/oder unterscheiden sich in ihrer Materialzusammensetzung. Die einzelnen Schichten können jeweils eine Schichtdicke von 5 µm (Mikrometer) bis 100 µm, bevorzugt 8 µm bis 80 µm aufweisen.

Zumindest eine der Mehrzahl von Schichten der Beschichtung besteht (zumindest teilweise) aus einer Nickel-Phosphor-Legierung, wobei ein Massenanteil des Phosphors in der Nickel-Phosphor-Legierung mindestens 8% beträgt. Der Massenanteil des Phosphors in der Nickel-Phosphor-Legierung beträgt bevorzugt 8% bis 14%, besonders bevorzugt 10% bis 12%. Die Schicht mit der Nickel-Phosphor-Legierung kann auf der Oberfläche galvanisch bzw. elektrolytisch abgeschieden werden. Alternativ oder kumulativ können auch weitere Schichten der Beschichtung, insbesondere die erste Schicht und/oder die zweite Schicht galvanisch bzw. elektrolytisch abgeschieden werden. Hierzu kann das Bauteil insbesondere zumindest teilweise in mindestens eine entsprechende galvanische bzw. elektrolytische Lösung getaucht werden. Diese Methode ist gegenüber beispielsweise der autokatalytischen Aufbringung wesentlich schneller ausführbar und damit besser für die industrielle Großserienfertigung geeignet.

Die Nickel-Phosphor-Legierung übernimmt in dem Mehrschichtsystem insbesondere die Funktion des Korrosionsschutzes. Somit kann die Nickel-Phosphor-Legierung in hohem Maße Korrosion an dem Bauteil verhindern und somit die Korrosionseigenschaften insbesondere von dekorativen Beschichtungen mit funktionalem Charakter verbessern. Schädigungen, unvollständig geschlossene oder poröse Beschichtungen können daher zu einem erheblich reduzierten Korrosionsverlauf des Gegenstands führen, sodass ein Bauteilversagen und/oder optische Beeinträchtigungen vermieden werden.

Auf dieser Nickel-Phosphor-Legierung wird eine weitere Schicht insbesondere durch physikalische oder chemische Gasphasenabscheidung (PVD- oder CVD-Verfahren) erzeugt. Die Herstellung des Schichtverbundes (von Schicht und weiterer Schicht) kann dabei beispielsweise durch eine Verkettung einer automatischen Galvanikanlage mit einer (Inline-)PVD-Anlage oder CVD-Anlage erfolgen. Es kann (alternativ) auch ein diskontinuierlicher Prozess vorgesehen sein, bei dem die galvanische(n) Schicht(en) und die PVD- oder CVD-Schicht unabhängig voneinander abgeschieden werden.

Die weitere Schicht der Beschichtung, die mittels Gasphasenabscheidung aufgebracht wird, bildet insbesondere eine Deckschicht bzw. äußerste Schicht der Beschichtung. Bei der Deckschicht kann es sich beispielsweise um eine dekorative Deckschicht des Bauteils handeln. Weiterhin kann die Deckschicht zumindest teilweise eine Sichtoberfläche des Bauteils bilden. Die weitere Schicht weist insbesondere eine Schichtdicke im Bereich von 0,1 µm bis 3 µm, bevorzugt von 0,2 µm bis 0,6 µm auf. In diesen vergleichsweise geringen Schichtdicken überwiegen insbesondere die dekorativen Eigenschaften der Beschichtung gegenüber Härtungseigenschaften.

Dass die weitere Schicht "direkt" auf die Nickel-Phosphor-Legierungsschicht aufgebracht wird, bedeutet mit anderen Worten auch, dass keine Chromschicht zwischen diesen beiden Schichten angeordnet ist. Insbesondere wird das Verfahren (insgesamt) ohne galvanische bzw. elektrolytische Verchromung durchgeführt. Dies trägt in vorteilhafter Weise auch zur Reduzierung von Entgiftungsbehandlungen der eingesetzten Stoffe bei. Insbesondere durch die Substitution einer galvanischen Verchromung durch eine PVD-Schicht fallen keine Abwasserbehandlungen mehr für chromhaltige Abwässer an, die bei der galvanischen Verchromung entstehen würden.

Nach einer vorteilhaften Ausgestaltung wird vorgeschlagen, dass der Grundkörper mit Kupfer, Zink, Eisen, Kunststoff oder einer Legierung gebildet ist, die Kupfer, Zink oder Stahl umfasst. Der Grundkörper kann beispielsweise zur Wasserführung eingerichtet sein bzw. mindestens einen Wasserweg bilden. Wasserführende Sanitärbauteile, wie zum Beispiel Einhebelmischer und/oder Ausläufe, können zumindest teilweise aus Kupferlegierungen (Messing, Bronze) bestehen. Viele Anbauteile in der Sanitärindustrie bestehen aus Zinkdruckguss (zum Beispiel Hebel für Einhebelmischer, Gehäuse und/oder Ausläufe). Kunststoffe werden im Sanitärbereich in der Regel für Kappen, Drückerplatten, Rosetten und/oder Hülsen verwendet und können dekorativ gestaltet sein. In diesem Zusammenhang kann beispielsweise ABS (Acrylnitril-Butadien-Styrol oder Blendmaterial aus ABS/PC (PC=Polycarbonat) in verschiedenen Anteilen als Kunststoff eingesetzt werden.

Nach einer weiteren vorteilhaften Ausgestaltung wird vorgeschlagen, dass eine erste Schicht der Beschichtung zumindest teilweise mit oder aus Kupfer gebildet ist. Bei der ersten Schicht der Beschichtung handelt es sich in der Regel um diejenige Schicht, die direkt auf die Oberfläche des Grundkörpers aufgebracht wird.

Nach einer weiteren vorteilhaften Ausgestaltung wird vorgeschlagen, dass eine zweite Schicht der Beschichtung zumindest teilweise mit Nickel gebildet ist. In diesem Zusammenhang kann die zweite Schicht der Beschichtung beispielhaft aus Mattnickel bestehen. Die zweite Schicht wird insbesondere direkt auf die erste Schicht aufgebracht.

Mattnickelschichten sind Nickelschichten, die aufgrund ihrer Zusammensetzung weitgehend blendfreie Eigenschaften aufweisen. Üblicherweise werden dem Elektrolyten bestimmte Substanzen zugesetzt, die die Nickelabscheidung beeinflussen. Da der Zweck dieser Schichten die Erzielung einer bestimmten Erscheinung ist, werden diese Schichten üblicherweise als Ersatz für Glanznickelschichten verwendet. Die Farbe und der Matteindruck können bei diesen Verfahren in einem gewissen Rahmen durch die Prozessparameter gesteuert werden. Die Mattnickelschicht kann beispielsweise mit einem Nickelelektrolyt ohne Einebner gebildet werden. Ein Vorteil der Mattnickelschicht kann auch darin bestehen, dass eine in das darunter liegende Kupfermaterial eingebrachte (Bürst-)Struktur durch die Mattnickelschicht nicht oder zumindest nicht signifikant bzw. vollständig eingeebnet wird.

Nach einer weiteren vorteilhaften Ausgestaltung wird vorgeschlagen, dass eine dritte Schicht der Beschichtung mit der Nickel-Phosphor-Legierung gebildet ist. Die dritte Schicht wird insbesondere direkt auf die zweite Schicht aufgebracht.

Nach einer weiteren vorteilhaften Ausgestaltung wird vorgeschlagen, dass eine vierte Schicht der Beschichtung mit der weiteren Schicht gebildet ist. Die vierte Schicht wird insbesondere direkt auf die dritte Schicht aufgebracht.

Es kann (alternativ) vorgesehen sein, dass eine mit der Nickel-Phosphor-Legierung gebildete Schicht direkt auf den Grundkörper oder als zweite Schicht direkt auf die erste (Kupfer-)Schicht aufgebracht wird. Dies kann auch so verstanden werden, dass zumindest die zweite (Nickel-) Schicht ausgelassen werden kann. In diesem Zusammenhang kann die weitere Schicht direkt auf die mit der Nickel-Phosphor-Legierung gebildete Schicht aufgebracht werden.

Nach einer weiteren vorteilhaften Ausgestaltung wird vorgeschlagen, dass die weitere Schicht mit einer Zirkonverbindung, Chromverbindung oder Titanverbindung gebildet ist. Auch sind Mischungen dieser Verbindungen in der weiteren (vierten) Schicht möglich. Der Zweck dieser Beschichtung ist die Erstellung einer bestimmten Farbe. Beispielsweise können so Rottöne, Goldtöne oder Edelstahloptik auf der (zuvor galvanisch abgeschiedenen) Nickel-Phosphor-Schicht realisiert werden. Die Zusammensetzung dieser Schichten bestimmt hierbei insbesondere die erreichte Farbe. In insbesondere verschiedenen Anteilen kann die weitere Schicht beispielsweise aus Zirkonnitrid (ZrN), Titannitrid (TiN) und/oder Chromnitrid (CrN) bestehen.

Nach einer weiteren vorteilhaften Ausgestaltung wird vorgeschlagen, dass die weitere Schicht mittels physikalischer Gasphasenabscheidung (PVD-Verfahren) gebildet wird. Die weitere Schicht kann dabei insbesondere zumindest teilweise mit Zirkon, Chrom und/oder Titan gebildet werden.

Beispielsweise können die erste Schicht und/oder die zweite Schicht und/oder die dritte Schicht hintereinander mittels einer (automatischen) Galvanikanlage aufgebracht werden. Weiterhin kann die vierte Schicht (unmittelbar) daran (anschließend) mittels einer PVD-Anlage aufgebracht werden. Dabei kann die PVD-Anlage zumindest teilweise in und/oder (unmittelbar) an der Galvanikanlage platziert sein (sog. Inline-PVD-Anlage). Dadurch kann in vorteilhafter Weise ein (insgesamt) kontinuierlicher Beschichtungsprozess realisiert werden.

Nach einer weiteren vorteilhaften Ausgestaltung wird vorgeschlagen, dass die weitere Schicht zumindest teilweise mit amorphem Kohlenstoff gebildet wird. Bei der amorphen Kohlenstoffschicht handelt es sich insbesondere um eine diamantartige Kohlenstoffschicht (DLC = *"diamond-like carbon*").

Weiterhin ist es vorteilhaft, wenn in die Beschichtung eine Bürstenstruktur eingebracht wird. Das Aufbringen einer Bürstenstruktur wird meist in Verbindung mit der bereits erwähnten PVD- bzw. DLC-Beschichtung durchgeführt. Resultierende Endoberflächen sind zum Beispiel "gebürsteter Edelstahl" oder "gebürstetes Nickel". Das Bürsten kann durch Andrücken der Gegenstände an rotierende Scheiben durchgeführt werden. Diese Scheiben können zum Beispiel Polierringe mit entsprechenden Polierpasten, Fiberbürsten oder Sisalbürsten sein. Dieser Arbeitsschritt wir üblicherweise vor der PVD- bzw. DLC-Beschichtung durchgeführt.

Beispielsweise kann in eine (zu beschichtende) Oberfläche des Grundkörpers oder der vorzugsweise mit Kupfer gebildeten ersten Schicht eine (matte bzw. matt erscheinende) Struktur, insbesondere eine Bürstenstruktur (bzw. Bürststruktur) eingebracht werden. Die Kombination von einer in eine darunter liegende Oberfläche eingebrachten Struktur und einer (direkt) darüber aufgebrachten mit der Nickel-Phosphor-Legierung gebildeten Schicht weist insbesondere den Vorteil auf, dass die Struktur durch die mit der Nickel-Phosphor-Legierung gebildete Schicht nicht oder zumindest nicht signifikant bzw. vollständig eingeebnet wird. Eine solche Einebnung könnte beispielsweise passieren, wenn eine Glanznickelschicht auf die Struktur aufgebracht wird. Insoweit kann die mit der Nickel-Phosphor-Legierung gebildete Schicht auch dazu beitragen, die (Bürst-)Struktur vorteilhaft zu erhalten. Gleichzeitig kann die mit der Nickel-Phosphor-Legierung gebildete Schicht zu einem Korrosionsschutz beitragen.

Nach einem weiteren Aspekt wird auch ein Bauteil für eine Wasserarmatur vorgeschlagen, bei dem eine Oberfläche eines Grundkörpers des Bauteils zumindest teilweise mit einer Beschichtung beschichtet ist, die eine Mehrzahl von Schichten aufweist, wobei zumindest eine Schicht der Beschichtung mit einer Nickel-Phosphor-Legierung gebildet ist und wobei ein Massenanteil des Phosphors in der Nickel-Phosphor-Legierung mindestens 8% beträgt. Das Bauteil zeichnet sich dadurch aus, dass direkt auf zumindest einen Teil dieser Schicht eine weitere Schicht der Beschichtung mittels Gasphasenabscheidung aufgebracht ist. Das Bauteil kann zum Beispiel nach einem hier beschriebenen Verfahren hergestellt sein.

Die im Zusammenhang mit dem Verfahren erörterten Details, Merkmale und vorteilhaften Ausgestaltungen können entsprechend auch bei dem hier vorgestellten Bauteil auftreten und umgekehrt. Insoweit wird auf die dortigen Ausführungen zur näheren Charakterisierung der Merkmale vollumfänglich Bezug genommen.

Die hier vorgestellte Lösung sowie deren technisches Umfeld werden nachfolgend anhand der Figuren näher erläutert. Es ist darauf hinzuweisen, dass die Erfindung durch die gezeigten Ausführungsbeispiele nicht beschränkt werden soll. Insbesondere ist es, soweit nicht explizit anders dargestellt, auch möglich, Teilaspekte der in oder in Zusammenhang mit den Figuren erläuterten Sachverhalte zu extrahieren und mit anderen Bestandteilen und/oder Erkenntnissen aus anderen Figuren und/oder der vorliegenden Beschreibung zu kombinieren. Es zeigen beispielhaft und schematisch:

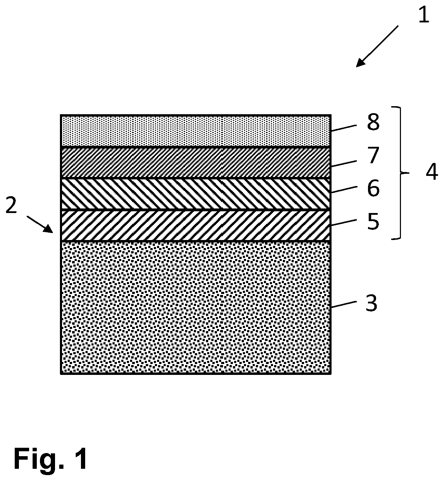

- Fig. 1:: ein hier beschriebenes Bauteil für eine Wasserarmatur.

Fig. 1 zeigt beispielhaft und schematisch ein hier beschriebenes Bauteil 1 für eine Wasserarmatur, bei dem eine Oberfläche 2 eines Grundkörpers 3 für das Bauteil 1 zumindest teilweise mit einer Beschichtung 4 beschichtet ist, die eine Mehrzahl von Schichten 5, 6, 7, 8 aufweist, wobei zumindest eine Schicht 7 der Beschichtung mit einer Nickel-Phosphor-Legierung gebildet ist und wobei ein Massenanteil des Phosphors in der Nickel-Phosphor-Legierung mindestens 8% beträgt. Dabei ist direkt auf zumindest einen Teil dieser Schicht 7 eine weitere Schicht 8 der Beschichtung 4 mittels Gasphasenabscheidung aufgebracht.

Der Grundkörper 3 kann dabei mit Kupfer, Zink, Eisen, Kunststoff oder einer Legierung gebildet sein, die Kupfer, Zink oder Stahl umfasst. Eine erste Schicht 5 der Beschichtung 4 kann zumindest teilweise mit Kupfer gebildet sein. Eine zweite Schicht 6 der Beschichtung 4 kann zumindest teilweise mit Nickel gebildet sein. Eine dritte Schicht 7 der Beschichtung 4 ist hier beispielhaft mit der Nickel-Phosphor-Legierung gebildet. Weiterhin ist beispielsweise eine vierte Schicht 8 der Beschichtung 4 mit der weiteren Schicht 8 gebildet, die hier beispielhaft eine Deckschicht 8 der Beschichtung 4 bildet.

Die weitere Schicht 8 kann mit einer Zirkonverbindung, Chromverbindung oder Titanverbindung gebildet sein. Dabei kann die Deckschicht 8 mittels physikalischer Gasphasenabscheidung (PVD-Verfahren) gebildet sein. Darüber hinaus kann die weitere Schicht 8 (alternativ) auch zumindest teilweise mit amorphem Kohlenstoff bzw. mit einer DLC-Schicht gebildet sein.

Es hat sich überraschend herausgestellt, dass bei dem beschriebenen Mehrschichtsystem auf die galvanische bzw. elektrolytische Verchromungsschicht (zwischen der dritten und vierten Schicht) verzichtet werden kann, ohne wesentliche Einbußen bei der Korrosionsbeständigkeit und der dekorativen Gestaltbarkeit in Kauf nehmen zu müssen. Dies lässt sich insbesondere damit erklären, dass durch den Phosphorgehalt von mindestens 8% der Schichtverbund mit der mittels Gasphasenabscheidung aufgebrachten weiteren Schicht ausreichend korrosionsbeständig ist, was bei einem üblichen Schichtverbund Nickel/PVD oder Nickel/DLC nicht der Fall wäre. Dadurch kann auf eine galvanisch bzw. elektrolytisch aufgebrachte Chrom(-zwischen)-Schicht verzichtet werden, wodurch der Reinigungsaufwand für chromhaltige Abwässer zumindest reduziert werden kann.

Somit können die mit Bezug zum Stand der Technik geschilderten Probleme zumindest teilweise gelöst werden. Insbesondere können ein Verfahren und ein Bauteil angegeben werden, die eine ressourcenschonende und umweltschonende Beschichtung erlauben, die gleichwohl möglichst korrosionshemmend und/oder dekorativ gestaltbar ist.

### Bezugszeichenliste

- 1: Bauteil
- 2: Oberfläche
- 3: Grundkörper
- 4: Beschichtung
- 5: erste Schicht
- 6: zweite Schicht
- 7: dritte Schicht
- 8: vierte Schicht/Deckschicht

## Patentansprüche

1. Verfahren zur Herstellung eines Bauteils (1) für eine Wasserarmatur, bei dem eine Oberfläche (2) eines Grundkörpers (3) für das Bauteil (1) zumindest teilweise mit einer Beschichtung (4) beschichtet wird, die eine Mehrzahl von Schichten (5, 6, 7, 8) aufweist, wobei zumindest eine Schicht (7) der Beschichtung mit einer Nickel-Phosphor-Legierung gebildet wird und wobei ein Massenanteil des Phosphors in der Nickel-Phosphor-Legierung mindestens 8% beträgt, **dadurch gekennzeichnet, dass** direkt auf zumindest einen Teil dieser Schicht (7) eine weitere Schicht (8) der Beschichtung (4) mittels Gasphasenabscheidung aufgebracht wird.

2. Verfahren nach Anspruch 1, wobei der Grundkörper (3) mit Kupfer, Zink, Eisen, Kunststoff oder einer Legierung gebildet ist, die Kupfer, Zink oder Stahl umfasst.

3. Verfahren nach Anspruch 1 oder 2, wobei eine erste Schicht (5) der Beschichtung (4) zumindest teilweise mit Kupfer gebildet ist.

4. Verfahren nach einem der vorhergehenden Ansprüche, wobei eine zweite Schicht (6) der Beschichtung (4) zumindest teilweise mit Nickel gebildet ist.

5. Verfahren nach einem der vorhergehenden Ansprüche, wobei eine dritte Schicht (7) der Beschichtung (4) mit der Nickel-Phosphor-Legierung gebildet ist.

6. Verfahren nach einem der vorhergehenden Ansprüche, wobei eine vierte Schicht (8) der Beschichtung (4) mit der weiteren Schicht (8) gebildet ist.

7. Verfahren nach einem der vorhergehenden Ansprüche, wobei die weitere Schicht (8) mit einer Zirkonverbindung, Chromverbindung oder Titanverbindung gebildet ist.

8. Verfahren nach einem der vorhergehenden Ansprüche, wobei die weitere Schicht (8) mittels physikalischer Gasphasenabscheidung (PVD-Verfahren) gebildet wird.

9. Verfahren nach einem der Ansprüche 1 bis 6, wobei die weitere Schicht (8) zumindest teilweise mit amorphem Kohlenstoff gebildet wird.

10. Bauteil (1) für eine Wasserarmatur, bei dem eine Oberfläche (2) eines Grundkörpers (3) des Bauteils (1) zumindest teilweise mit einer Beschichtung (4) beschichtet ist, die eine Mehrzahl von Schichten (5, 6, 7, 8) aufweist, wobei zumindest eine Schicht (7) der Beschichtung mit einer Nickel-Phosphor-Legierung gebildet ist und wobei ein Massenanteil des Phosphors in der Nickel-Phosphor-Legierung mindestens 8% beträgt, **dadurch gekennzeichnet, dass** direkt auf zumindest einen Teil dieser Schicht (7) eine weitere Schicht (8) der Beschichtung (4) mittels Gasphasenabscheidung aufgebracht ist.
